(19)

Europäisches Patentamt

European Patent Office

Office européen des brevets

(11) **EP 3 447 519 A1**

(12) **EUROPEAN PATENT APPLICATION**

(43) Date of publication:
**27.02.2019 Bulletin 2019/09**

(51) Int Cl.:
***G01R 33/565*** *(2006.01)*

(21) Application number: **17187026.4**

(22) Date of filing: **21.08.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Koninklijke Philips N.V.**
**5656 AE Eindhoven (NL)**

(72) Inventor: **XIE, Bin**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **A METHOD AND APPARATUS FOR GRADIENT DELAY MEASUREMENT OF A MAGNETIC RESONANCE IMAGING SYSTEM**

(57) The invention provides a magnetic resonance imaging (MRI) system. The MRI system comprises a plurality of gradient coils configured to produce field gradients along axes of the MRI system, a gradient controller coupled to the gradient coils and configured to control application of the field gradients along the axes, a sequence controller coupled to the gradient controller and configured to produce demand gradient waveforms calculated based on scan parameters of a MRI scanning for application of demand field gradients along the axes, and a gradient delay measuring device configured to measure a gradient delay on each axis of the MRI system between actual gradient waveform of actual field gradient produced along the each axis by the gradient coils and the demand gradient waveform of the demand field gradient along the each axis. The gradient delay measuring device further comprises at least one coil loop configured to generate at least one induction voltage respectively indicative of a change in the magnetic flux through the at least one coil loop due to application of the actual field gradient produced along the each axis by the gradient coils, and a gradient delay estimator coupled to the at least one coil loop and configured to estimate the gradient delay on the each axis by comparing the demand gradient waveform on the each axis with at least one voltage waveform of the at least one induction voltage.

FIG.2

## Description

FIELD OF THE INVENTION

The invention relates to magnetic resonance imaging systems, and more particularly to gradient delay measurement of magnetic resonance imaging systems.

BACKGROUND OF THE INVENTION

In an MRI device, an examination object, usually a patient, is exposed to a uniform main magnetic field (B0 field) so that the magnetic moments of the nuclei within the examination object tend to rotate around the axis of the applied B0 field. Then, by transmitting an RF excitation pulse (B1 field) which is orthogonal to the B0 field, generated by means of an RF transmit antenna, the spins of the nuclei are excited and brought into phase, and a deflection of their net magnetization from the direction of the B0 field is obtained, so that a transversal component in relation to the longitudinal component of the net magnetization is generated.

In order to obtain a spatial selection of a slice or volume within the examination object and a spatial encoding of the received MR relaxation signals emanating from a slice or volume of interest, gradient magnetic fields are superimposed on the $B_0$ field, having the same direction as the $B_0$ field, but having gradients in the orthogonal x-, y- and z-directions.

For generating the gradient magnetic fields, a gradient magnet system comprising a number of gradient magnets in the form of gradient coils is provided which is typically operated by means of a gradient amplifier system for generating electrical currents for supplying the gradient coils. Usually, many MR imaging techniques that utilize the high-performance capabilities of modern gradient amplifier systems are sensitive to distortion of the expected gradient waveforms caused by a variety of causes. Aside from uncompensated eddy current effects leading to distortions of the waveform shape, another significant problem is small timing delay errors arising in the hardware.

WO03054570 proposes to determine during a pulse a quantity representing the conducting state of the conductors of the gradient system and to use a model of the MRI apparatus to measure and calculate the gradient delay, thereby providing a better gradient delay compensation for the variation in temperature of the gradient coil. However, in addition to the temperature variation in the gradient coil, these concealed timing delays exist between the application of a gradient waveform to the gradient amplifiers and the subsequent response of the gradient coils. Furthermore, there is often anisotropy in the physical delays that relate to each gradient axis. These system delay errors can lead to significant artifacts using some image acquisition methods, for example, in echo-planar imaging (EPI), spiral imaging, and projection reconstruction. To address these problems, initial gradient delays are measured during system installation and used as unchanged hardware parameters assuming that the delays relating to the three gradient axes are identical for all sequences and don't change over time.

SUMMARY OF THE INVENTION

From the foregoing, it is readily appreciated that there is a need for providing a more accurate gradient delay measurement for a MRI system, which is robust to dynamic delay change. It is consequently an object of the invention to enable an accurate gradient delay measurement in the presence of dynamic delay change. The object of the present invention is achieved by the subject matter of the independent claims. Embodiments are given in the dependent claims.

In accordance with the invention, a magnetic resonance imaging (MRI) system is disclosed. The MRI system comprises:

- a plurality of gradient coils configured to produce field gradients along axes of the MRI system;
- a gradient controller coupled to the gradient coils and configured to control application of the field gradients along the axes;
- a sequence controller coupled to the gradient controller and configured to produce demand gradient waveforms calculated based on scan parameters of a MRI scanning for application of demand field gradients along the axes;
- a gradient delay measuring device configured to measure a gradient delay on each axis of the MRI system between actual gradient waveform of actual field gradient produced along the each axis by the gradient coils and the demand gradient waveform of the demand field gradient along the each axis, the gradient delay measuring device further comprising:

  at least one coil loop configured to generate at least one induction voltage respectively indicative of a change in the magnetic flux through the at least one coil loop due to application of the actual field gradient produced along the each axis by the gradient coils; and

- a gradient delay estimator coupled to the at least one coil loop and configured to estimate the gradient delay on the each axis by comparing the demand gradient waveform on the each axis with at least one voltage waveform of the at least one induction voltage.

Advantageously, by placing the at least one coil loop to sense the change in the magnetic flux, measurement of the gradient delay on each axis between the actual gradient waveform of the actual field gradient and the demand gradient waveform of the demand field gradient is transformed to measurement of timing delay between the gradient waveform of demand gradient waveform and the voltage waveform of the induction voltage generated by the at least one coil loop. As such, dynamic change in the actual gradient filed can be sensed and processed timely, which enables accurate gradient delay measurement in the presence of dynamic delay change.

In accordance with one embodiment of the invention, the gradient delay estimator further comprises an analog to digital converter configured to sample the at least one induction voltage and convert the at least one induction voltage to at least one digitalized induction voltage, and a comparator configured to generate the gradient delay on the each axis by comparing timings of at least one voltage waveform of the at least one digitalized induction voltage and the demand gradient waveform of the demand field gradient along the each axis. Advantageously, the accuracy of gradient delay measurement is determined by the accuracy of the analog to digital converter, given there is no other electronics in the setup that will potentially bring extra delays. Gigahertz data samplers that are commercially available can make delay measurement at sub-nanosecond level feasible.

In accordance with another embodiment of the invention, the sequence controller is further configured to advance the demand gradient waveform by the gradient delay on the each axis to compensate for the gradient delay on the each axis. Advantageously, dynamically changed delay is corrected retrospectively based on the measured gradient delays on each axis.

In accordance with yet another embodiment of the invention, the at least one coil loop comprise a solenoid. Advantageously, the number of windings of the solenoid can be increased to get enough signal-to-noise (SNR) for the induction voltage when the solenoid area A has to be limited in practical implementation.

In accordance with yet another embodiment of the invention, the gradient delay measuring device measures the gradient delay on the each axis during a pre-scanning session of the MRI scanning.

In accordance with yet another embodiment of the invention, the gradient delay measuring device measures the gradient delay on the each axis on a real-time basis during the MRI scanning.

In accordance with the invention, a method for measuring a gradient delay on an axis of a MRI system is further disclosed. The method comprise the steps of generating at least one induction voltage respectively indicative of a change in the magnetic flux through at least one coil loop due to application of actual field gradients by the gradient coils, comparing the demand gradient waveform on the axis with at least one voltage waveform of the at least one induction voltage, and estimating the gradient delay on the axis based on the comparing.

In accordance with the invention, a gradient delay measuring device configured to measure a gradient delay on an axis of a MRI system is further disclosed. The gradient delay measuring device comprises at least one coil loop configured to generate at least one induction voltage respectively indicative of a change in the magnetic flux through the at least one coil loop due to application of actual field gradients by the gradient coils, and a gradient delay estimator coupled to the at least one coil loop and configured to estimate the gradient delay on the axis by comparing the demand gradient waveform on the axis with at least one voltage waveform of the at least one induction voltage.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Aspects of the present invention are described with reference to flowchart illustrations and/or block diagrams of methods, apparatus (systems) and computer program products according to embodiments of the invention. It will be understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

BRIEF DESCRIPTION OF THE DRAWINGS

The enclosed drawings disclose preferred embodiments of the invention. It should be understood, however, that the drawings are designed for the purpose of illustration only and not as a definition of the limits of the invention. In the drawings:

Fig. 1 shows a conventional magnetic resonance imaging (MRI) system;
Fig. 2 shows a MRI system according to one embodiment of the present invention;
Fig. 3 shows a comparision between a plot representative of a voltage waveform of the induction voltage V generated in response to application of actual field gradients and a plot representative of demand gradient waveforms of the demand field gradients.
Fig. 4 shows a flowchart illustrating an exemplary method of measuring a gradient delay on an axis of a MRI system according to one embodiment of the present invention.

DETAILED DESCRIPTION OF THE EMBODIMENTS

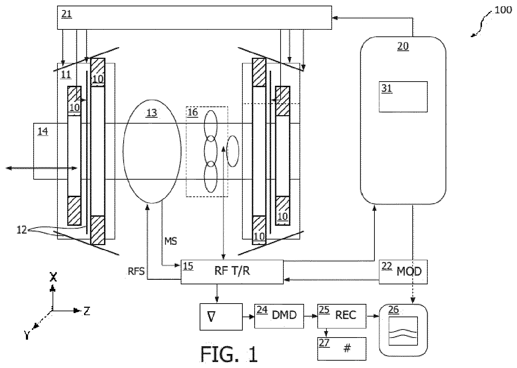

Figure 1 shows diagrammatically a conventional magnetic resonance imaging (MRI) system 100. The magnetic resonance imaging system 100 includes a set of main coils 10 whereby the steady, uniform magnetic field is generated. The main coils 10 are constructed, for example in such a manner that they enclose a tunnel-shaped examination space. The patient to be examined is placed on a patient carrier 14 which is slid into this tunnel-shaped examination space. The magnetic resonance imaging system also includes a number of gradient coils 11, 12 whereby magnetic fields exhibiting spatial variations, notably in the form of temporary gradients in individual directions X, Y and Z, are generated so as to be superposed on the uniform magnetic field. The X, Y and Z nomenclature refers to the imaginary orthogonal axes used in describing MRI systems, wherein the Z axis is an axis coaxial with the axis of the bore hole of the mail magnet system, the X axis is the vertical axis extending from the center of the magnetic field, and the Y axis is the corresponding horizontal axis orthogonal to the Z axis and the X axis. The gradient coils 11, 12 are connected to a gradient controller 21 which includes one or more gradient amplifier and a controllable power supply unit. The gradient coils 11, 12 are energized by application of an electric current by means of the power supply unit 21; to this end the power supply unit is fitted with electronic gradient amplification circuit that applies the electric current to the gradient coils so as to generate gradient waveforms (also termed 'gradient pulses') of appropriate temporal shape. The strength, direction and duration of the gradients are controlled by control of the power supply unit.

The RF system of the magnetic resonance imaging system 100 includes transmission and receiving coils 13, 16 for generating the RF excitation pulses and for picking up the magnetic resonance signals, respectively. The transmission coil 13 is preferably constructed as a body coil 13 whereby (a part of) the object to be examined can be enclosed. The body coil is usually arranged in the magnetic resonance imaging system in such a manner that the patient to be examined is enclosed by the body coil 13 when he or she is arranged in the magnetic resonance imaging system. The body coil 13 acts as a transmission antenna for the transmission of the RF excitation pulses and RF refocusing pulses. Preferably, the body coil 13 involves a spatially uniform intensity distribution of the transmitted RF pulses (RFS). The same coil or antenna is usually used alternately as the transmission coil and the receiving coil. Furthermore, the transmission and receiving coil is usually shaped as a coil, but other geometries where the transmission and receiving coil acts as a transmission and receiving antenna for RF electromagnetic signals are also feasible. The transmission and receiving coil 13 is connected to an electronic transmission and receiving circuit 15.

It is to be noted that it is alternatively possible to use separate receiving and/or transmission coils 16. For example, surface coils 16 can be used as receiving and/or transmission coils. Such surface coils have a high sensitivity in a comparatively small volume. A demodulator is provided in the RF system. The receiving coils, such as the surface coils, are connected to the demodulator 24 and the received magnetic resonance signals (MS) are demodulated by means of the demodulator 24. The demodulated magnetic resonance signals (DMS) are applied to a reconstruction unit. The receiving coil is connected to a preamplifier 23. The preamplifier 23 amplifies the RF resonance signal (MS) received by the receiving coil 16 and the amplified RF resonance signal is applied to a demodulator 24. The demodulator 24 demodulates the amplified RF resonance signal. The demodulated resonance signal contains the actual information concerning the local spin densities in the part of the object to be imaged. Furthermore, the RF system includes a modulator 22 and the transmission and receiving circuit 15 is connected to the modulator 22. The modulator 22 and the transmission and receiving circuit 15 activate the transmission coil 13 so as to transmit the RF excitation and refocusing pulses. Magnetic resonance signal data received by the surface coils 16 are transmitted to the transmission and receiving circuit 15 and control signals (e.g. to tune and detune the surface coils) are sent to the surface coils by the control module 20.

The reconstruction unit derives one or more image signals from the demodulated magnetic resonance signals (DMS), which image signals represent the image information of the imaged part of the object to be examined. The reconstruction unit 25 in practice is constructed preferably as a digital image processing unit 25 which is programmed so as to derive from the demodulated magnetic resonance signals the image signals which represent the image information of the part of the object to be imaged. The signal on the output of the reconstruction monitor 26, so that the monitor can display the magnetic resonance image. It is alternatively possible to store the signal from the reconstruction unit 25 in a buffer unit 27 while awaiting further processing.

The magnetic resonance imaging system 100 is also provided with a control module 20, for example in the form of a computer which includes a (micro)processor. Notably, the control module 20 is configured or programmed to perform the MRI scanning which is played out to identify an implant or to track an interventional instrument. To this end, the computer program is loaded, for example, into the control module 20 and the reconstruction unit 25. The control module 20 controls, by way of a sequence controller 31, the execution of the RF excitations and the application of the temporary gradient fields. More specifically, the sequence controller 31 connects to an operator console (not shown) for receiving commands from the operator, which indicate the gradient waveform calculated based on scan parameters of a MRI scanning. These scan parameters include, but not limited to, such things as field of view, slice thickness, spin velocity and image resolution. From these scan parameters, demand gradient waveforms of demand field gradients along the X, Y and Z axis of the MRI system is calculated and downloaded to the sequence controller 31. The sequence controller 31 operates the gradient controller 21 and the gradient coils 11 and 12 to carry out the demand gradient waveforms. Unfortunately, due to the gradient delay as discussed previously, the actual gradient waveforms of the field gradients actually produced by the gradient coils 11 and 12 suffer from some timing shifts relative to the demand gradient waveforms arising in the hardware.

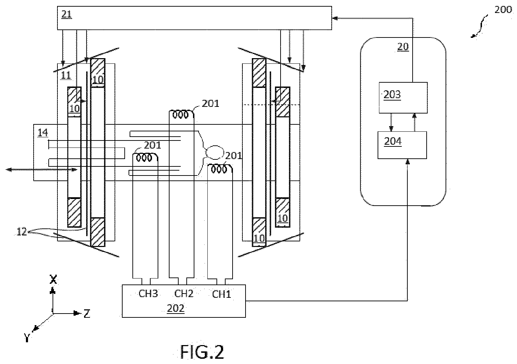

Fig. 2 shows diagrammatically a magnetic resonance imaging system 200 according to one embodiment of the present invention. A detailed description of components similar to those in Fig. 1 will be omitted herein for the sake of brevity. In the embodiment of Fig.2, the MRI system 200 further includes a gradient measuring device which comprises at least one coil loop 201 for generating at least one induction voltage V and a gradient delay estimator for estimating the gradient delay on each axis by leveraging the at least one induction voltage V.

As discussed with reference to Fig. 1, magnetic fields exhibiting spatial variations, notably in the form of temporary gradients in individual directions X, Y and Z, are generated so as to be superposed on the uniform magnetic field during imaging. Due to application of the actual field gradient along each axis, the at least one coil loop 201 placed in areas covered by such filed gradient will respond to the change of the magnetic field to generate at least one induction voltage V, repectively, according to Faraday's electromagnetic induction law. The induction voltage $V_i$ of coil loop $i$ is proportional to the rate (dG/dt) of the change in the magnetic flux as illustrated in equation (1)

$$V_i = -\sum_{j=x,y,z} \frac{d\emptyset_j}{dt} = -A \cdot \left( x_i \cdot \frac{dG_x(t-\tau_x)}{dt} + y_i \cdot \frac{dG_y(t-\tau_y)}{dt} + z_i \cdot \right.$$

$$\left. \frac{dG_z(t-\tau_z)}{dt} \right) \qquad (1),$$

where Φ represents the magnetic flux passing through the coil loop $i$ with an area A, $x_i$, $y_i$, and $z_i$ represent the *x, y* and *z* coordinates defining the position of the coil loop $i$, $\tau_x$, $\tau_y$, and $\tau_z$ represent the gradient delays on the *x, y* and *z* axes, respectively, and and $G_x$ $G_y$, and $G_z$ represent the gradient along the *x, y* and *z* axes, respectively.

Referring particularly to Fig. 2, for the purpose of illustration but not limitation, three coil loops are placed in the gradient field and the induction voltages generated by the coil loops are sampled by channels CH1 to CH3 of the analog to digital converter 202. Alternatively, a single coil loop is adequate for measuring the gradient delay on each axis of the MRI system 200 if the timing of the rising and falling edges of the demand gradient waveforms is not identical across any two of the axes. In this instance, gradient waveform on each of x, y and z axes includes a rising/falling edge that individually contributes to generation of the induction voltage, which means $\tau_x$, $\tau_y$, and $\tau_z$ is the only unknow value of equaltion 1) when solving the gradient delay problem for x, y and z axes, respectively. Consequently, a single coil loop is enough for measuring gradient delays $\tau_x$, $\tau_y$, and $\tau_z$. If there exists identical timing of the rising and falling edges of demand gradient waveforms across only two of the axes, at least two coil loops placed at different spatial locaitons are required for measuring the gradient delay on each axis. In this instance, identical gradient waveforms on the two of x, y and z axes, e.g., identical gradient waveforms on x and y axes, include identical rising/falling edges that jointly contribute to generation of the induction voltage, which means $\tau_x$ and $\tau_y$ are unknow values of equaltion 1) when solving the gradient delay problem for x and y axes. While, gradient waveform on z axis includes a rising/falling edge that individually contributes to generation of the induction voltage, which means $\tau_z$ is the only unknow value of equaltion 1) when solving the gradient delay problem for z axis. Consequenty, an addition coil loop placed at a different spatial location is needed to provide another equation such that $\tau_x$ and $\tau_y$ can be solved jointly by equations describing induction voltage generation of the two coil loops. Similary, If the timing of the rising and falling edges of gradient waveforms across all three axes are identical, at least three coil loops placed at different spatial locations are required for measuring the gradient delay on each axis. By placing more coil loops in different positions as field probes, it is feasible to correct spatial dependent eddy current and gradient waveform infidelity.

In one embodiment, the coil loops comprise solenoids. The number of windings of the solenoid can be increased to get enough signal-to-noise (SNR) for the induction voltage V when the solenoid area A has to be limited in practical implementation, e.g., when the solenoids are placed in RF coil or in patient carrier. It can be contemplated that the coil loop can be in other form as long as the purpose of generating the induction voltage with enough SNR can be achieved.

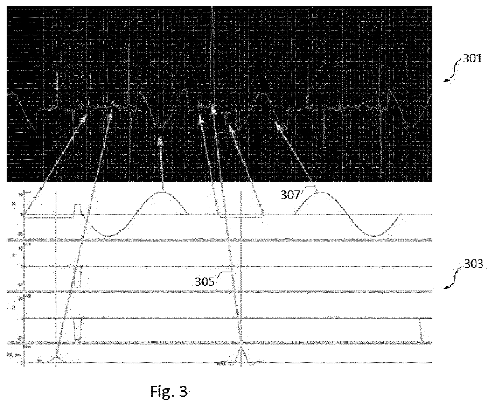

In the embodiment of Fig. 2, the induction voltage V is further provided to a gradient delay estimator which comprises an analog to digital converter 202 and a comparator 204. The analog to digital converter 202 samples the at least one induction voltage V and converts the at least one induction voltage V to at least one digitalized induction voltage. The at least one digitalized induction voltage is further provided to the comparator 204, which solves the equation 1) by comparing the demand gradient waveforms on the three axes and the at least one voltage waveform of the at least one digitalized induction voltage. In one embodiment, the implementation of the comparator 204 is to maximize the cross correlation between the voltage induction V(t) and known demand gradient waveform G(t). Alternatively, a least square curve fitting can also be used. It is contemplated by the skilled in the art that various other algorithms can be adopted to solve the gradient delay problem of equation 1) by comparing demand gradient waveforms on the three axes with at least one voltage waveform of the at least one digitalized induction voltage. Actually, since the value of the induction voltage in each coil loop is proportional to the slew rate of the actual gradient waveform on each axis, the voltage waveform of each induction voltage is affected by the gradient delays in all three axes jointly, which will be described in more details with reference to Fig. 3.

In practice, the accuracy of gradient delay measurement is determined by the accuracy of the analog to digital converter 202, given there is no other electronics in the setup that will potentially bring extra delays. Gigahertz data samplers that are commercially available can make delay measurement at sub-nanosecond level feasible. Moreover, instead of embedding the comparator 204 into the control module 20, the comparator 204 can be embedded in the analog to digital converter 202 or in the form of a standalone device.

Fig. 3 illustrates a comparision between a plot 301 representative of a voltage waveform of an induction voltage V generated in response to application of actual field gradients and a plot 303 representative of demand gradient waveforms of the demand field gradients. For the purpose of illustration but not limitation, the timing of the rising and falling edges of the demand gradient waveforms on x, y and z axes is not identical across any two of the axes, and a sinusoidal motion encoding gradient is specifically designed for the demand gradient waveform on the X axis, which facilicates the recognition of the induction voltage in a pure cosine shape as indicated by arrow 307. Since the sinusoidal motion encoding gradient on the X axis is the only rising and faling edges across all three axies at the timing of its application, the delay between the timing of the sinusoidal encoding gradient on the X axis and the timing of the cosine shape induction voltage indicates the measured gradient delay on the X axis of the MRI system. As indicated in Fig. 3, each rising and falling edges of the gradient waveforms on the X, Y and Z axis corresponds to a voltage pulse in the voltage waveform of the induction voltage. By comparing the timing of the demand gradient waveforms on the X, Y and Z axis and the timing of the voltage waveform of the induction voltage, the gradient delays on the X, Y and Z axis are readily conceivable. Furthermore, RF pulse also induces a voltage pulse as indicated by arrow 305, which can be used as a reference in calcuating gradient delays on each axis.

Referring back to Fig. 2, the comparator 204 is coupled to the analog and digital converter 202 for receiving the at least one digitalized induction voltage and further coupled to the sequence controller 203 for receiving the demand gradient waveforms. By comparing the demand gradient waveforms and the voltage waveform of the digitalized induction voltage as discussed previously in connection with solving the gradient delay problems, the comparator 204 generates the gradient delay on the each axis. Advantageously, the gradient delay generated by the comparator 204 can be further provided to the sequence controller 203 which advances the demand gradient waveform by the gradient delay on the each axis to compensate for the gradient delay.

In implementation, the gradient measuring device can operate to measure the gradient delay during a pre-scanning session of the MRI scanning. Alternatively, the graident measuring device can operate to mesure the gradient dely on a real-time basis duirng the MRI scanning. In both instances, dynamically changing delays can be correted retrospectively by the sequence controller 203 using the recorded induction voltage.

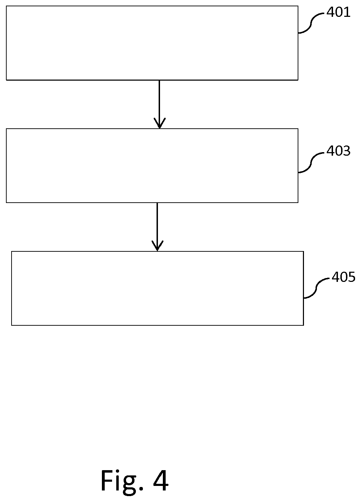

Fig. 4 is a flowchart illustrating an exemplary method 400 of measuring a gradient delay on an axis of a MRI system 200 between actual gradient waveform of actual field gradient produced along the axis by gradient coils 11, 13 of the MRI system 200 and demand gradient waveform of demand field gradient along the axis calculated based on scan parameters of a MRI scanning by a sequence controller 203 of the MRI system 200.

In a step 401, due to application of actual field gradients by the gradient coils 11 and 13, at least one induction voltage respectively indicative of a change in the magnetic flux through at least one coil loop 201 is generated.

In a step 403, the demand gradient waveform on the axis is compared with the at least one voltage waveform of the at least one induction voltage. In one embodiment, the comparing is to maximize the cross correlation between the voltage induction V(t) and known demand gradient waveform G(t). Alternatively, a least square curve fitting can also be used for the comparing. In the embodiment of Fig. 3, by comparing the timing of the demand gradient waveforms on the X, Y and Z axis and the timing of the voltage waveform of the induction voltage, the gradient delays on the X, Y and Z axis are readily conceivable.

In a step 405, the gradient delay on the axis is estimated based on the comparing. As aforementioned, the gradient delay problem of equation 1) is solved by the comparing based on cross correction maximization, least square curve fitting, visually timing comparison or the like.

The embodiments described above are illustrative examples and it should not be construed that the present invention is limited to these particular embodiments. Thus, various changes and modifications may be effected by one skilled in the art without departing from the spirit or scope of the invention as defined in the appended claims.

**Claims**

1. A magnetic resonance imaging (MRI) system (200) comprising:

   - a plurality of gradient coils (11, 12) configured to produce field gradients along axes of the MRI system;
   - a gradient controller (21) coupled to the gradient coils (11, 12) and configured to control application of the field gradients along the axes;
   - a sequence controller (203) coupled to the gradient controller (21) and configured to produce demand gradient waveforms calculated based on scan parameters of a MRI scanning for application of demand field gradients along the axes;
   - a gradient delay measuring device (201, 202, 204) configured to measure a gradient delay on each axis of the MRI system (200) between actual gradient waveform of actual field gradient produced along the each axis by the gradient coils (11, 12) and the demand gradient waveform of the demand field gradient along the each axis, the gradient delay measuring device (201, 202) further comprising:

      - at least one coil loop (201) configured to generate at least one induction voltage respectively indicative of a change in the magnetic flux through the at least one coil loop (201) due to application of the actual field gradient produced along the each axis by the gradient coils (11, 12); and
      - a gradient delay estimator (202, 204) coupled to the at least one coil loop (201) and configured to estimate the gradient delay on the each axis by comparing the demand gradient waveform on the each axis with at least one voltage waveform of the at least one induction voltage.

2. The MRI system of claim 1, wherein the gradient delay estimator (202, 204) further comprises:

   an analog to digital converter (202) configured to sample the at least one induction voltage and convert the at least one induction voltage to at least one digitalized induction voltage.

3. The MRI system of claim 2, further comprising:

   a comparator (204) configured to generate the gradient delay on the each axis based onat least one voltage waveform of the at least one digitalized induction voltage and the demand gradient waveform of the demand field gradient on the each axis.

**4.** The MRI system of any of proceeding claims, wherein the sequence controller (203) is further configured to advance the demand gradient waveform by the estimated gradient delay on the each axis to compensate for the gradient delay on the each axis.

**5.** The MRI system of any of proceeding claims, wherein the at least one coil loop comprises a solenoid.

**6.** The MRI system of any of proceeding claims, wherein the gradient delay measuring device (201, 202, 204) measures the gradient delay on the each axis during a pre-scanning session of the MRI scanning.

**7.** The MRI system of any of claims 1-5, wherein the gradient delay measuring device (201, 202, 204) measures the gradient delay on the each axis on a real-time basis during the MRI scanning.

**8.** A method for measuring a gradient delay on an axis of a MRI system (200) between actual gradient waveform of actual field gradient produced along the axis by gradient coils (11, 13) of the MRI system (200) and demand gradient waveform of demand field gradient along the axis calculated based on scan parameters of a MRI scanning by a sequence controller (203) of the MRI system (200), the method comprising:

- generating at least one induction voltage respectively indicative of a change in the magnetic flux through at least one coil loop (201) due to application of actual field gradients by the gradient coils (11, 13);
- comparing the demand gradient waveform on the axis with at least one voltage waveform of the at least one induction voltage; and
- estimating the gradient delay on the axis based on the comparing.

**9.** The method of claim 8, further comprising:

advancing the demand gradient waveform by the estimated gradient delay on the axis.

**10.** The method of any of claims 8-9, wherein the at least one coil loop (201) comprises a solenoid.

**11.** A gradient delay measuring device configured to measure a gradient delay on an axis of a MRI system (200) between actual gradient waveform of actual field gradient produced along the axis by gradient coils (11, 13) of the MRI system (200) and demand gradient waveform of demand field gradient along the axis calculated based on scan parameters of a MRI scanning by a sequence controller (203) of the MRI system (200), the gradient delay measuring device comprises:

- at least one coil loop (201) configured to generate at least one induction voltage respectively indicative of a change in the magnetic flux through the at least one coil loop (201) due to application of actual field gradients by the gradient coils (11, 13); and
- a gradient delay estimator (202, 204) coupled to the at least one coil loop (201) and configured to estimate the gradient delay on the axis by comparing the demand gradient waveform on the axis with at least one voltage waveform of the at least one induction voltage.

**12.** The gradient delay measuring device of claim 11, wherein the gradient delay estimator (202, 204) further comprises:

- an analog to digital converter (202) configured to sample the at least one induction voltage and convert the at least one induction voltage to at least one digitalized induction voltage; and
- a comparator (204) configured to generate the gradient delay on the axis based on at least one voltage waveform of the at least one digitalized induction voltage and the demand gradient waveform of the demand field gradient on the axis.

FIG. 1

FIG.2

Fig. 3

Fig. 4

Europäisches Patentamt
European Patent Office
Office européen des brevets

# EUROPEAN SEARCH REPORT

Application Number

EP 17 18 7026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SENAJ VILIAM ET AL: "Inductive measurement of magnetic field gradients for magnetic resonance imaging", REVIEW OF SCIENTIFIC INSTRUMENTS, AIP, MELVILLE, NY, US, vol. 69, no. 6, 1 June 1998 (1998-06-01), pages 2400-2405, XP012036628, ISSN: 0034-6748, DOI: 10.1063/1.1148966 * Sections I, II, IV.B, V * | 1-12 | INV. G01R33/565 |
| X | CN 102 540 125 A (UNIV EAST CHINA NORMAL; SHANGHAI COLORFUL MAGNETIC RESONANCE TECHNOLOG) 4 July 2012 (2012-07-04) * machine translation, p. 2, last paragraph, p. 3, first paragraph * | 1-12 | |
| X | US 2014/327438 A1 (BARMET CHRISTOPH [CH] ET AL) 6 November 2014 (2014-11-06) * paragraph [0060] - paragraph [0073] * * paragraph [0082] - paragraph [0087] * * figures 1, 3 * | 1-12 | |
| X | SIGNE J. VANNESJO ET AL: "Gradient system characterization by impulse response measurements with a dynamic field camera", MAGNETIC RESONANCE IN MEDICINE, vol. 69, no. 2, 12 April 2012 (2012-04-12), pages 583-593, XP055081659, ISSN: 0740-3194, DOI: 10.1002/mrm.24263 * Sections "Theory and Methods", "Results" * | 1-6,8-12 | TECHNICAL FIELDS SEARCHED (IPC) G01R |

The present search report has been drawn up for all claims

| Place of search | Date of completion of the search | Examiner |
|---|---|---|
| Munich | 8 March 2018 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 18 7026

This annex lists the patent family members relating to the patent documents cited in the above-mentioned European search report.
The members are as contained in the European Patent Office EDP file on
The European Patent Office is in no way liable for these particulars which are merely given for the purpose of information.

08-03-2018

| Patent document cited in search report | | | Publication date | Patent family member(s) | | Publication date |
|---|---|---|---|---|---|---|
| CN 102540125 | A | | 04-07-2012 | NONE | | |
| US 2014327438 | A1 | | 06-11-2014 | EP | 2515132 A1 | 24-10-2012 |
| | | | | EP | 2699919 A1 | 26-02-2014 |
| | | | | US | 2014327438 A1 | 06-11-2014 |
| | | | | WO | 2012143574 A1 | 26-10-2012 |

For more details about this annex : see Official Journal of the European Patent Office, No. 12/82

**EP 3 447 519 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03054570 A